# EUROPÄISCHE PATENTANMELDUNG

(11) **EP 4 650 616 A1**
(43) Veröffentlichungstag der Anmeldung: **19.11.2025**
(21) Anmeldenummer: 25176998.0
(22) Anmeldetag: 16.05.2025
(51) Int. Cl.: F16C 33/04, C23C 14/06, F01D 17/16, F16C 17/18

(54) **GLEITLAGERANORDNUNG UND FLUGTRIEBWERK MIT EINER GLEITLAGERANORDNUNG**

(30) Priorität: 17.05.2024 DE 102024113983
(71) Anmelder: MTU Aero Engines AG, 80995 München (DE)
(72) Erfinder: Faller, Joachim, 80995 München (DE); Mosbacher, Mike, 80995 München (DE)

(57) **Zusammenfassung**

Die Erfindung betrifft eine 1. Gleitlageranordnung (14), insbesondere für ein Flugtriebwerk, umfassend ein erstes Bauteil (10) und ein zweites Bauteil (12), wobei das erste Bauteil (10) gleitend am zweiten Bauteil (12) gelagert ist und wobei das erste und/oder das zweite Bauteil (10, 12) wenigstens eine tribologische Beschichtung (18) aufweist, wobei die Beschichtung (18) eine einschichtige, amorphe Kohlenstoffbeschichtung mit einem sp²-Anteil und einem sp³-Anteil ist, wobei der sp³-Anteil bezogen auf die gesamte Stoffmenge der Beschichtung (18) zwischen 50 at.-% und 75 at.-% beträgt. Die Erfindung betrifft weiterhin ein Flugtriebwerk umfassend eine solche Gleitlageranordnung (14).

## Beschreibung

Die Erfindung betrifft eine Gleitlageranordnung und ein Flugtriebwerk mit einer solchen Gleitlageranordnung.

Flugtriebwerke und andere Gasturbinen umfassen im Allgemeinen einen Verdichter, um Luft zu verdichten, eine Brennkammer, um einen Kohlenwasserstoffbrennstoff in Gegenwart der unter Druck stehenden Luft zu verbrennen, und eine Turbine, um Energie aus den entstehenden Verbrennungsgasen zu gewinnen. Flugtriebwerke verfügen dabei über zahlreiche Gleitlagereinrichtungen, in denen ein erstes Bauteil gleitend bewegbar an einem zweiten Bauteil gelagert ist. Gleitlager sind generell tribologische Elemente, die Lasten aufnehmen und direkten Kontakt zwischen zwei sich relativ zueinander bewegbaren Bauteilen haben. Dabei kann es sich um eine lineare oder rotatorische Gleitbewegung handeln. Um dem Einfluss von hohen Temperaturen und Vibrationen zu begegnen, weist mindestens eines der Bauteile im Gleitbereich wenigstens eine tribologische Beschichtung aus einem amorphen Kohlenstoffmaterial auf. Amorphe Kohlenstoffmaterialien weisen keine regelmäßige kristalline Struktur auf, sondern liegen in einem amorphen oder nichtkristallinen Zustand vor. Im Gegensatz zu kristallinem Kohlenstoff, der eine geordnete Gitterstruktur aufweist, sind amorphe Kohlenstoffschichten ungeordnet und besitzen abweichende strukturelle Eigenschaften. Die Beschichtung aus amorphen Kohlenstoffmaterialien dient zur Reibungsminderung und verbessert die Verschleißfestigkeit.

Aus der US 11 566 535 B1 ist eine tribologische Beschichtung für drehbare Leitschaufeln bekannt, die aus mehreren Schichten amorpher Kohlenstoffmaterialien mit einem Wasserstoffgehalt von bis zu 30 Atomprozent (at.-%) besteht. Diese Form der Gleitlagerung der Leitschaufeln basiert darauf, dass im Einlauf zwischen Zapfen und Buchse ein dritter Körper in Form eines graphitreichen Films entsteht. Dieser reduziert die Reibwerte und damit die dissipierte Energie, was wiederum den Verschleiß an Zapfen und Buchse senkt.

In der Praxis wird dieser Mechanismus aber häufig durch die Umgebungsbedingungen gehemmt, sodass es sowohl zu starkem Abtrag der Buchsen, als auch zu Verschleiß der Zapfen kommt. Durch Verschleiß am Zapfen und/oder an den Buchsen kommt es in Folge zu großen Auslenkungen der Leitschaufeln und unter Umständen zu Kontakt mit weiteren Baugruppen des Verdichters. Außerdem sind diese mehrschichtigen Beschichtungen sehr aufwändig in der Herstellung.

Aufgabe der vorliegenden Erfindung ist es, eine Gleitlageranordnung anzugeben, welche einfacher herstellbar ist und verbesserte Gleiteigenschaften besitzt. Eine weitere Aufgabe der Erfindung ist, ein Flugtriebwerk mit wenigstens einer solchen Gleitlageranordnung anzugeben.

Die Aufgabe wird erfindungsgemäß durch eine Gleitlageranordnung gemäß Anspruch 1 sowie durch ein Flugtriebwerk gemäß Anspruch 10 gelöst. Vorteilhafte Ausgestaltungen mit zweckmäßigen Weiterbildungen der Erfindung sind in den Unteransprüchen angegeben, wobei vorteilhafte Ausgestaltungen der Gleitlageranordnung als vorteilhafte Ausgestaltungen des Flugtriebwerks und umgekehrt anzusehen sind.

Ein erster Aspekt der Erfindung betrifft eine Gleitlageranordnung für ein Flugtriebwerk, umfassend ein erstes Bauteil und ein zweites Bauteil, wobei das erste Bauteil eine verstellbare Leitschaufel und das zweite Bauteil ein Verdichtergehäusebauteil ist, wobei das erste Bauteil gleitend am zweiten Bauteil gelagert ist und wobei das erste und/oder das zweite Bauteil wenigstens eine tribologische Beschichtung aufweist. Erfindungsgemäß ist die Beschichtung eine einschichtige, amorphe Kohlenstoffbeschichtung mit einem sp²-Anteil und einem sp³-Anteil ist, wobei der sp³-Anteil bezogen auf gesamte Beschichtung zwischen 50 at.-% und 75 at.-% beträgt. Die erfindungsgemäße Beschichtung ist im Vergleich zu bekannten Beschichtungen also nicht mehrschichtig, sondern einschichtig ausgebildet, wodurch sie einfacher herstellbar ist. Die erfindungsgemäße Beschichtung, die auch als "diamond-like carbon" Schicht (DLC-Schicht) bezeichnet werden kann, besitzt zudem eine hohe Härte und kann leicht auf Metalloberflächen aufgebracht werden. Der anfänglich hohe sp³-Kohlenstoffgehalt der Beschichtung wird dann durch die Reibung zwischen den Bauteilen, das heißt durch den tribologischen Kontakt, der Gleitlageranordnung zumindest in der Randzone zu sp²-Kohlenstoff umhybridisiert, wodurch sich an der Oberfläche der Beschichtung automatisch eine hohe Reibungsminderung einstellt. Die Beschichtung wirkt damit einerseits als Verschleißschutzschicht und andererseits reibungsmindernd, da sie die Bauteile im Gleitbereich vor Verschleiß schützt und trotzdem durch Ausbildung einer Art Kohlenstofftransferfilm eine gleitende Relativbewegung der Bauteile zueinander ermöglicht. Grundsätzlich kann die Beschichtung nur auf dem ersten Bauteil oder auf dem zweiten Bauteil angeordnet sein. Ebenso ist es möglich die Beschichtung auf beiden Bauteilen vorzusehen.

In einer vorteilhaften Ausgestaltung der Erfindung ist vorgesehen, dass ein Anteil an hydrogeniertem Kohlenstoff bezogen auf die gesamte Stoffmenge der Beschichtung weniger als 10 at.-%, insbesondere weniger als 1 at.-% und vorzugsweise 0 at.-% beträgt. Mit anderen Worten weist die erfindungsgemäße Beschichtung nur einen sehr niedrigen Wasserstoffgehalt auf oder ist vorzugsweise frei von Wasserstoff. Bevorzugt besteht die Beschichtung damit im Wesentlichen oder ausschließlich nur aus sp³- und sp²-hybridisiertem Kohlenstoff. Hierdurch werden eine besonders hohe Härte und Verschleißbeständigkeit sichergestellt, ohne die tribologischen Eigenschaften nachteilig zu beeinflussen.

Weitere Vorteile ergeben sich, indem der sp³-Anteil bezogen auf die gesamte Stoffmenge der Beschichtung zwischen 55 at.-% und 70 at.-% beträgt. Hierdurch können für unterschiedliche Gleitlagerungstypen optimale Verschleißfestigkeiten bei gleichzeitig hervorragender Gleitreibungsminderung realisiert werden.

Erfindungsgemäß sind das erste Bauteil und das zweite Bauteil Bauteile eines Verstellsystems eines Verdichters eines Flugtriebwerks, wobei insbesondere das erste Bauteil eine verstellbare Leitschaufel und das zweite Bauteil ein Verdichtergehäusebauteil ist. Da im Verdichterbereich von Flugtriebwerken gegenüber dem Turbinenbereich nur vergleichsweise niedrige Temperaturbelastungen auftreten, weist die erfindungsgemäße Beschichtung damit eine besonders hohe Lebensdauer auf. Insbesondere wenn das erste Bauteil eine verstellbare Leitschaufel und das zweite Bauteil ein Verdichtergehäusebauteil ist, sorgt die Beschichtung der erfindungsgemäßen Gleitlageranordnung für einen besonders geringen Verschleiß bei gleichzeitig guten Gleiteigenschaften, so dass die Funktionalität der Leitschaufelverstellung des zugeordneten Verdichters über einen besonders langen Zeitraum gewährleistet werden kann. Vorzugsweise ist die Beschichtung in dieser Ausführungsform zumindest auf der Leitschaufel aufgebracht.

In weiterer Ausgestaltung der Erfindung ist es vorgesehen, dass das erste Bauteil und das zweite Bauteil ein Kugelgelenk bilden. Auch in diesem Fall können die vorteilhaften Eigenschaften der Beschichtung der Gleitlageranordnung hinsichtlich Reibungsminderung und Verschleißschutz vorteilhaft für ein wichtiges Konstruktionselement realisiert werden.

In einer weiteren vorteilhaften Ausgestaltung der Erfindung ist vorgesehen, dass das erste Bauteil wenigstens einen Zapfen und das zweite Bauteil wenigstens eine Buchse aufweist, wobei der Zapfen des ersten Bauteils gleitend drehbar in der Buchse des zweiten Bauteils gelagert ist. Eine Buchse hat generell eine (hohl-) zylindrische Form und ermöglicht eine relative Drehbewegung des Zapfens durch Gleiten. Die Buchse kann auch als Lagerbuchse oder Gleitlagerbuchse bezeichnet werden. Das zweite Bauteil kann beispielsweise ein Gehäuseteil mit einer Buchse sein. In einfachster Ausgestaltung ist das zweite Bauteil eine Buchse.

Weitere Vorteile ergeben sich, indem wenigstens ein Zapfen des ersten Bauteils und/oder wenigstens eine Buchse des zweiten Bauteils mindestens zwei voneinander beabstandete Beschichtungen aufweist. Mit anderen Worten ist die Beschichtung auf dem Zapfen und/oder in der Buchse nicht durchgängig über die gesamte Gleitoberfläche ausgebildet, so dass Oberflächenbereiche unbeschichtet sind. Vorzugsweise sind zwei Beschichtungen an jeweiligen Endbereichen des Zapfens und/oder der Buchse ausgebildet. Hierdurch kann der Reibwiderstand verringert werden. Darüber hinaus können auf den Zapfen wirkende Radialkräfte besser kompensiert werden, da auch bei einem Verkippen des Zapfens in der Buchse sichergestellt ist, dass eine Berührung zwischen Zapfen und Buchse und ein Abgleiten des Zapfens an der Buchse ausschließlich über beschichtete Oberflächenbereiche erfolgt. Allgemein wird angemerkt, dass sich die Begriffe "Axial-" bzw. "axial", "Radial-" bzw. "radial" und "Umfangs-" im Rahmen der vorliegenden Offenbarung auf die Rotationsachse des Zapfens beziehen, sofern sich aus dem Kontext nicht implizit oder explizit etwas anderes ergibt.

Weitere Vorteile ergeben sich, indem die Beschichtung eine Schichtdicke zwischen 500 nm und 2000 nm, insbesondere zwischen 500 nm und 1500 nm besitzt. Eine derartige Schichtdicke stellt für die meisten Anwendungsfälle ein Optimum von Reibungsminderung und Verschleißschutz sicher.

In einer weiteren vorteilhaften Ausgestaltung der Erfindung ist vorgesehen, dass die Beschichtung durch Gasphasenabscheidung, bevorzugt durch physikalische Gasphasenabscheidung (PVD), durch Sputtern oder durch eine Kombination davon aufgebracht ist. Insbesondere die Verwendung von PVD ermöglicht eine besonders präzise Kontrolle der Schichtdicke und der Zusammensetzung der Beschichtung hinsichtlich ihres sp²-/sp³-Anteils bei vergleichsweise niedrigen Temperaturen und sorgt für eine gute Haftung der Beschichtung am Bauteil.

Ein zweiter Aspekt der Erfindung betrifft ein Flugtriebwerk, umfassend wenigstens eine Gleitlageranordnung gemäß dem ersten Erfindungsaspekt. Die sich hieraus ergebenden Merkmale und deren Vorteile sind den Beschreibungen des ersten Erfindungsaspekts zu entnehmen. Vorzugsweise weist das Flugtriebwerk mehrere Gleitlageranordnungen als Teil eines Leitschaufelverstellsystems eines Verdichters auf. Jede Gleitlageranordnung umfasst dabei jeweils eine verstellbare Leitschaufel als erstes Bauteil und zwei einander gegenüberliegende Buchsen als zweite Bauteile, in denen jeweils ein endständiger Zapfen der Leitschaufel angeordnet ist. Dabei ist die Beschichtung der erfindungsgemäßen Gleitlageranordnung vorzugsweise zumindest an den Zapfen der Leitschaufel(n) angeordnet bzw. ausgebildet. Hierdurch können die Leitschaufeln einfach und wartungsarm verstellt werden, ohne dass es zu erhöhtem Verschleiß und damit verbundenen großen Auslenkungen der Leitschaufeln und etwaigem Kontakt mit weiteren Baugruppen des Verdichters kommt.

Weitere Eigenschaften und Variationen dieser Erfindung ergeben sich aus den Ansprüchen, den Abbildungen und der Abbildungsbeschreibung. Sowohl die Merkmale und Kombinationen von Merkmalen, die oben in der Beschreibung erwähnt wurden, als auch diejenigen, die in den Abbildungen gezeigt und beschrieben werden oder in den Abbildungen allein dargestellt sind, können nicht nur in den angegebenen Kombinationen, sondern auch in anderen Kombinationen verwendet werden, ohne den Rahmen der Erfindung zu verlassen. Daher werden auch Ausführungsformen der Erfindung als miterfasst und offenbart betrachtet, die nicht explizit in den Abbildungen gezeigt und erläutert werden, jedoch aus den beschriebenen Merkmalskombinationen abgeleitet und erzeugt werden können. Ebenso sind Ausführungsformen und Merkmalskombinationen als offenbart zu betrachten, die nicht alle Merkmale eines ursprünglich formulierten unabhängigen Anspruchs aufweisen. Darüber hinaus sind auch Ausführungsformen und Merkmalskombinationen als offenbart anzusehen, die über die in den Rückbezügen der Ansprüche dargelegten Merkmalskombinationen hinausgehen oder von ihnen abweichen. Dabei zeigt:
- Fig. 1: eine schematische Schnittansicht einer verstellbaren Leitschaufel einer erfindungsgemäßen Gleitlageranordnung;
- Fig. 2: eine schematische Schnittansicht einer Buchse der erfindungsgemäßen Gleitlageranordnung; und
- Fig. 3: ein Ternärdiagramm amorpher Kohlenstoffmaterialien.

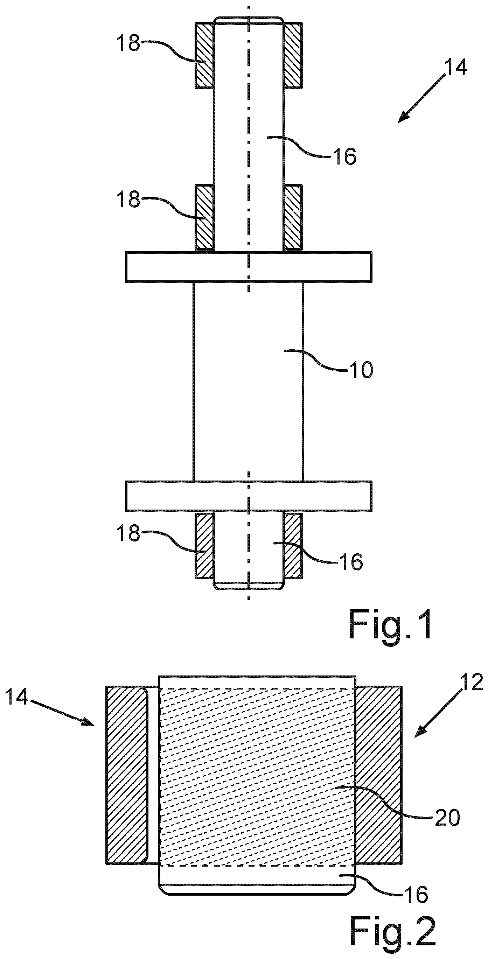

**FIG. 1** zeigt eine schematische Schnittansicht eines ersten Bauteils 10, das als verstellbare Leitschaufel ausgebildet ist. Die Leitschaufel 10 bildet zusammen mit zwei Buchsen (Fig. 2) als zweite Bauteile 12 eine erfindungsgemäße Gleitlageranordnung 14 für ein verstellbares Leitschaufelsystem eines Verdichters eines Flugtriebwerks (nicht gezeigt). Die Buchsen 12 können Teil eines Verdichtergehäusebauteils sein. Die Leitschaufel 10 umfasst zwei gegenüberliegende, endständige Zapfen 16, die jeweils mit einer tribologischen Beschichtung 18 versehen sind. Die Beschichtung 18 ist jeweils als einschichtige, amorphe Kohlenstoffbeschichtung mit einem sp²-Anteil und einem sp³-Anteil auf die Zapfen 16 aufgebracht, wobei der sp³-Anteil bezogen auf die gesamte Stoffmenge der Beschichtung 18 zwischen 50 at.-% und 70 at.-% beträgt. Die Beschichtung 18 wird vorzugsweise durch physikalische Gasphasenabscheidung erzeugt und besitzt eine Schichtdicke zwischen 500 nm und 2000 nm. Durch den einschichtigen Aufbau vereinfachen sich sowohl der Herstellungsprozess als auch die Qualitätssicherung bzw. Analytik erheblich gegenüber bisher üblichen Mehrschichtsystemen aus amorphen C:H:Si:O Mehrlagen-/Gradientenschichten.

Man erkennt, dass auf den radial inneren Zapfen 16 eine Beschichtung 18 und auf den radial äußeren Zapfen 16 zwei voneinander beabstandete Beschichtungen 18 aufgebracht sind, wobei jede der Beschichtungen 18 vollständig umlaufend ausgebildet ist. Durch die zwei voneinander beabstandeten Beschichtungen 18 an den jeweiligen Endbereichen des radial äußeren Zapfens 16 können gegenüber einer vollständigen Beschichtung des Zapfens 16 Reibungsminderungen erzielt und auf die Leitschaufel 10 wirkende Radialkräfte, die zu einem Verkippen der Leitschaufel 10 führen können, besonders zuverlässig kompensiert werden. Die Beschichtungen 18 können hinsichtlich ihrer Zusammensetzung und Schichtdicke jeweils gleich oder unterschiedlich ausgebildet sein.

**Fig. 2** zeigt eine schematische Schnittansicht einer der beiden Buchsen 12 der erfindungsgemäßen Gleitlageranordnung 14, in welcher der radial innere Zapfen 16 der in Fig. 1 gezeigten Leitschaufel 10 angeordnet ist. Die gleitende Lagerung der Leitschaufel 10 basiert darauf, dass im Einlauf der Gleitlageranordnung 14 ein dritter Gleitkörper 20 in Form eines graphitreichen Films auf dem Zapfen 16 entsteht. Dieser Gleitkörper 20 reduziert die Reibwerte und damit die dissipierte Energie, was wiederum den Verschleiß an Zapfen 16 und Buchsen 12 senkt.

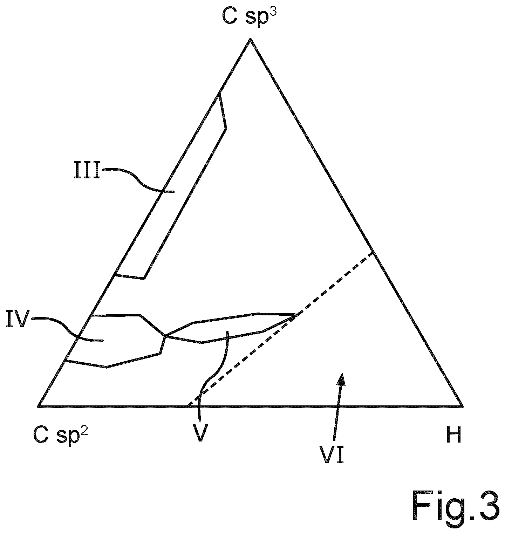

**Fig. 3** zeigt ein Ternärdiagramm amorpher Kohlenstoffmaterialien, wobei die Eckpunkte der Achsen die drei Komponenten sp²-hybridisierter Kohlenstoff (sp²-C), sp³-hybridisierter Kohlenstoff (sp³-C) und Wasserstoff (H) repräsentieren. Die Ecken des Dreiecks repräsentieren also jeweils die "reinen" Komponenten, während die Achsen binäre Gemische der betreffenden Komponenten charakterisieren. Innerhalb des Dreiecks liegen dann ternäre Mischungen aus den drei Komponenten. Mit Pfeil III ist ein Bereich der Beschichtung 18 der erfindungsgemäßen Gleitlageranordnung 14 gekennzeichnet. Man erkennt, dass die Beschichtung 18 der erfindungsgemäßen Gleitlageranordnung 14 überwiegend aus sp³-hybridisiertem Kohlenstoff besteht, dessen Anteil insbesondere zwischen 50 at.-% und 70 at.-% liegt. Weiterhin sieht man, dass die Beschichtung 18 zumindest im Wesentlichen frei von Wasserstoff ist.

Mit den Pfeilen IV und V sind demgegenüber aus dem Stand der Technik bekannte Beschichtungen mit einem wesentlich höheren sp²-C-Anteil bzw. H-Anteil gekennzeichnet. Der Pfeil VI markiert schließlich einen Bereich, in dem aufgrund des hohen Wasserstoffanteils im Allgemeinen keine Filmbildung und damit keine Beschichtung mehr möglich ist.

### Bezugszeichenliste:

- 10: erstes Bauteil, Leitschaufel
- 12: zweites Bauteil, Buchse
- 14: Gleitlageranordnung
- 16: Zapfen
- 18: Beschichtung
- 20: Gleitkörper
- III: Bereich der erfindungsgemäßen Komponentenmischung
- IV, V: nicht-erfindungsgemäße Komponentenmischungen
- VI: Bereich ohne Filmbildung

## Patentansprüche

1. Gleitlageranordnung (14) für ein Flugtriebwerk, umfassend eine verstellbare Leitschaufel (10) und ein Verdichtergehäusebauteil (12), wobei gleitend am Verdichtergehäusebauteil (12) gelagert ist und wobei die verstellbare Leitschaufel (10) und/oder das Verdichtergehäusebauteil (12) wenigstens eine tribologische Beschichtung (18) aufweist,
**dadurch gekennzeichnet, dass**
die Beschichtung (18) eine einschichtige, amorphe Kohlenstoffbeschichtung mit einem sp²-Anteil und einem sp³-Anteil ist, wobei der sp³-Anteil bezogen auf die gesamte Stoffmenge der Beschichtung (18) zwischen 50 at.-% und 75 at.-% beträgt.

2. Gleitlageranordnung (14) nach Anspruch 1,
**dadurch gekennzeichnet, dass**
ein Anteil an hydrogeniertem Kohlenstoff bezogen auf die gesamte Stoffmenge der Beschichtung (18) weniger als 10 at.-%, insbesondere weniger als 1 at.-% und vorzugsweise 0 at.-% beträgt.

3. Gleitlageranordnung (14) nach Anspruch 1 oder 2,
**dadurch gekennzeichnet, dass**
der sp³-Anteil bezogen auf die gesamte Stoffmenge der Beschichtung (18) zwischen 55 at.-% und 70 at.-% beträgt.

4. Gleitlageranordnung (14) nach einem der Ansprüche 1 bis 3,
**dadurch gekennzeichnet, dass** die verstellbare Leitschaufel (10) und das Verdichtergehäusebauteil (12) ein Kugelgelenk bilden.

5. Gleitlageranordnung (14) nach einem der Ansprüche 1 bis 4,
**dadurch gekennzeichnet, dass**
die verstellbare Leitschaufel (10) wenigstens einen Zapfen (16) und das Verdichtergehäusebauteil (12) wenigstens eine Buchse aufweist, wobei der Zapfen (16) der Leitschaufeln (10) gleitend drehbar in der Buchse des Gehäusebauteils (12) gelagert ist.

6. Gleitlageranordnung (14) nach Anspruch 5,
**dadurch gekennzeichnet, dass**
wenigstens ein Zapfen (16) der verstellbare Leitschaufel (10) und/oder wenigstens eine Buchse des Verdichtergehäusebauteils (12) mindestens zwei voneinander beabstandete Beschichtungen (18) aufweist.

7. Gleitlageranordnung (14) nach einem der Ansprüche 1 bis 6,
**dadurch gekennzeichnet, dass**
die Beschichtung (18) eine Schichtdicke zwischen 500 nm und 2000 nm, insbesondere zwischen 500 nm und 1500 nm besitzt.

8. Gleitlageranordnung (14) nach einem der Ansprüche 1 bis 7,
**dadurch gekennzeichnet, dass**
die Beschichtung (18) durch Gasphasenabscheidung, bevorzugt durch physikalische Gasphasenabscheidung, durch Sputtern oder durch eine Kombination davon aufgebracht ist.

9. Flugtriebwerk, umfassend wenigstens eine Gleitlageranordnung (14) gemäß einem der Ansprüche 1 bis 8.
